# EUROPÄISCHE PATENTSCHRIFT

(11) **EP 1 564 823 B1**
(45) Veröffentlichungstag und Bekanntmachung des Hinweises auf die Patenterteilung: **20.12.2006**
(21) Anmeldenummer: 05100173.3
(22) Anmeldetag: 13.01.2005
(51) Int. Cl.: H01L 41/047, H01L 41/22

(54) **Kontaktierungsmatte für einen Aktor, Positionierungshilfe hierfür und zugehöriges Verfahren**
Contact mat for an actuator, positioning assistance therefor and related fabrication method
Natte de contact pour un actionneur, aide positionnante pour telle natte et méthode relative de fabrication

(30) Priorität: 12.02.2004 DE 102004006978
(43) Veröffentlichungstag der Anmeldung: 17.08.2005
(73) Patentinhaber: SIEMENS AKTIENGESELLSCHAFT, 80333 München (DE)
(72) Erfinder: Adam, Marko, 09126, Chemnitz (DE); Haubold, Jörg, 09212, Limbach-Oberfrohna (DE); Heinek, Andreas, 01728, Bannewitz (DE); Lenk, Andreas, 01728 Bannewitz OT Possendorf (DE)

(56) Entgegenhaltungen:
- WO-A-20/04004021
- WO-A-20/05022657
- WO-A-20/05047689
- DE-A1- 10 026 635
- DE-A1- 19 930 585
- DE-C1- 19 715 488

## Beschreibung

Die Erfindung betrifft eine Kontaktierungsmatte zur elektrischen Kontaktierung eines Anschlussstifts eines Aktors mit einem zugehörigen Aktorkontakt eines Aktorkörpers des Aktors, gemäß dem Oberbegriff des Anspruchs 1, eine zugehörige Positionierungshilfe gemäß Anspruch 9 sowie ein zugehöriges Verfahren zur Herstellung eines Aktors.

Moderne Einspritzanlagen für Brennkraftmaschinen weisen zur mechanischen Ansteuerung der Injektoren zunehmend Piezoaktoren auf, die im Vergleich zu herkömmlichen elektromagnetischen Aktoren ein besseres dynamisches Verhalten aufweisen. Derartige Piezoaktoren haben herkömmlicherweise einen Piezostapel, in dem eine Vielzahl von schichtförmigen Piezoelementen übereinander angeordnet sind, wobei sich zwischen den einzelnen Piezoelementen jeweils schichtförmige Elektroden befinden. Die elektrische Kontaktierung des Piezostapels erfolgt durch Metallisierungsstreifen, die auf gegenüberliegenden Seitenflächen des Piezostapels angeordnet sind und über die gesamte Länge des Piezostapels reichen, wobei die einzelnen schichtförmigen Elektroden des Piezostapels abwechselnd mit einem der beiden Metallisierungsstreifen verbunden sind. Die beiden Metallisierungsstreifen sind wiederum mit zwei Anschlussstiften verbunden, die auf gegenüberliegenden Seiten des Piezostapels angeordnet sind und stirnseitig aus dem Piezoaktor herausragen, um an der Außenseite eine elektrische Kontaktierung zu ermöglichen.

Aus der WO 2005/047689 A1 und der WO 2005/022657 A1 sind Kontaktierungsmatten bekannt, die im vormontierten Zustand an den Aktorkörper eines Piezoaktors angebracht werden.

Aus der DE 197 50 488 C1 ist eine Positionierungshilfe bekannt, mit der die Anschlussstifte von Kontaktierungsmatten relativ zum Aktorkörper fixierbar sind.

Aus der DE 100 26 635 A1 und der DE 199 30 585 A1 ist eine Kontaktierungsmatte bekannt, die ein Drahtgeflecht aus elektrisch leitfähigen Drähten umfasst.

Die WO 2004/004021 A2 offenbart eine Positionierungshilfe für eine Kontaktierungsmatte, bei der zwei Distanzstücke zwei Aufnahmen zur Aufnahme und räumlichen Fixierung jeweils eines Anschlussstiftes aufweisen.

Aus DE 100 26 635 A1 ist es bekannt, zur elektrischen Verbindung der Metallisierungsstreifen des Piezostapels mit den zugehörigen Anschlussstiften eine Kontaktierungsmatte in Form eines Drahtgeflechts zu verwenden, wobei die Kontaktierungsmatte sogenannte Schussfäden und Kettfäden aufweist. Die Schussfäden sind hierbei parallel zueinander angeordnet, bestehen aus einem leitfähigen Material und verbinden die Metallisierungsstreifen des Piezostapels mit dem jeweils zugehörigen Anschlussstift. Die sogenannten Kettfäden verlaufen dagegen innerhalb der Kontaktierungsmatte rechtwinklig zu den Schussfäden und verbinden diese untereinander, um die Schussfäden mechanisch zu stabilisieren.

Nachteilig an dieser bekannten Kontaktierungsmatte ist jedoch die komplizierte Handhabung der Kontaktierungsmatte bei der Montage. So muss die bekannte Kontaktierungsmatte bei der Montage exakt so positioniert werden, dass die Kontaktierungsmatte auf der einen Seite an dem zugehörigen Anschlussstift des Aktors und auf der anderen Seite an dem zugehörigen Kontakt des Piezostapels elektrisch leitfähig befestigt werden kann.

Der Erfindung liegt deshalb die Aufgabe zugrunde, das Handling der Kontaktierungsmatte bei der Montage zu verbessern.

Diese Aufgabe wird, ausgehend von der vorstehend beschriebenen bekannten Kontaktierungsmatte gemäß dem Oberbegriff des Anspruchs 1, durch die kennzeichnenden Merkmale des Anspruchs 1 gelöst sowie durch eine Positionierungshilfe gemäß Anspruch 9 und ein entsprechendes Verfahren gemäß Anspruch 12.

Die Erfindung umfasst die allgemeine technische Lehre, an den ein Drahtgeflecht bildenden elektrisch leitfähigen Drähten der Kontaktierungsmatte mindestens einen Anschlussstift durch Einflechten vormontiert zu befestigen, so dass die Kontaktierungsmatte mittels der eingeflochtenen Anschlussstifte gehandhabt werden kann, was die Montage der erfindungsgemäßen Kontaktierungsmatte wesentlich erleichtert.

Beispielsweise kann das Drahtgeflecht entsprechend der vorstehend beschriebenen Druckschrift DE 100 26 635 A1 Schussfäden und Kettfäden aufweisen, wobei die Schussfäden im Wesentlichen in Längsrichtung der Kontaktierungsmatte bzw. rechtwinklig zu den Anschlussstiften verlaufen, während die Kettfäden quer zu den Schussfäden ausgerichtet sind.

Bei der erfindungsgemäßen Kontaktierungsmatte erfolgt die Verbindung zwischen der Kontaktierungsmatte und den Anschlussstiften für den Aktor nicht erst bei der Montage, sondern bereits bei der Herstellung der Kontaktierungsmatte als vormontiertes Teil.

Die elektrisch leitfähigen Drähte der Kontaktierungsmatte sind im Wesentlichen parallel zueinander angeordnet, während der Anschlussstift im Wesentlichen rechtwinklig zu den Drähten an diesen befestigt ist. Eine derartige parallele Anordnung der Drähte ist vorteilhaft, da die Drähte auf diese Weise im Betrieb des Aktors die Längenänderung des Aktorkörpers aufnehmen können, ohne dass große Zugspannungen auf die Drähte wirken.

Die Befestigung des Anschlussstiftes für den Aktor an den elektrischen leitfähigen Drähten der Kontaktierungsmatte kann beispielsweise durch eine Verlötung erfolgen, jedoch ist die Erfindung auch mit anderen Befestigungsarten realisierbar.

In dem bevorzugten Ausführungsbeispiel der Erfindung ist jedoch nicht nur ein einziger Anschlussstift an den elektrisch leitfähigen Drähten der Kontaktierungsmatte befestigt, sondern mehrere. Auf diese Weise kann eine fortlaufende Kontaktierungsmatte geschaffen werden, die zur Kontaktierung einer Vielzahl von Piezoaktoren ausreicht, wobei die Kontaktierungsmatte bei der eigentlichen Kontaktierung in entsprechende Teile aufgetrennt wird.

Der Abstand zwischen den an der Kontaktierungsmatte befestigten Anschlussstiften ist hierbei vorzugsweise im Wesentlichen äquidistant und ist vorzugsweise im Wesentlichen gleich der im fertig montierten Zustand eines Piezoaktors gegebenen Verbindungslänge zwischen einem Aktorkontakt und dem zugehörigen Anschlussstift.

Weiterhin ist zu erwähnen, dass der Anschlussstift oder die Anschlussstifte der erfindungsgemäßen Kontaktierungsmatte vorzugsweise seitlich über die Drähte hinausragt, wobei der Anschlussstift oder die Anschlussstifte einseitig oder beidseitig über die Drähte hinausragen können. Dies erleichtert vorteilhaft die Handhabung der erfindungsgemäßen Kontaktierungsmatte bei der eigentlichen Kontaktierung, weil die seitlich herausragenden freien Enden der Anschlussstifte zur Positionierung der Kontaktierungsmatte genutzt werden können, wie noch detailliert beschrieben wird.

Weiterhin ist zu erwähnen, dass die Erfindung nicht nur die vorstehend beschriebene erfindungsgemäße Kontaktierungsmatte umfasst, sondern auch einen Aktor, wie insbesondere einen Piezoaktor, der mit einer derartigen erfindungsgemäßen Kontaktierungsmatte kontaktiert ist.

Darüber hinaus umfasst die Erfindung auch eine Positionierungshilfe für die vorstehend beschriebene erfindungsgemäße Kontaktierungsmatte, wobei die erfindungsgemäße Positionierungshilfe die Handhabung der Kontaktierungsmatte bei der eigentlichen Kontaktierung erleichtert.

Hierzu weist die erfindungsgemäße Positionierungshilfe mindestens zwei Aufnahmen zur Aufnahme und räumlichen Fixierung jeweils eines Anschlussstiftes der Kontaktierungsmatte auf. Bei der Montage und endgültigen Kontaktierung des Aktors durch die Kontaktierungsmatte werden die an der Kontaktierungsmatte angebrachten Anschlussstifte also in die beiden schlitzförmigen Aufnahmen eingeführt, wobei die Anschlussstifte und damit auch die Kontaktierungsmatte räumlich fixiert werden.

Jede der beiden Aufnahmen der erfindungsgemäßen Positionierungshilfe ist hierbei für einen der beiden Anschlussstifte eines Piezoaktors vorgesehen.

Darüber hinaus ermöglicht die erfindungsgemäße Positionierungshilfe auch eine räumliche Fixierung des Aktorkörpers relativ zu den an der erfindungsgemäßen Kontaktierungsmatte angebrachten Anschlussstiften. Hierzu weist die erfindungsgemäße Positionierungshilfe eine weitere Aufnahme für den Aktorkörper auf, wobei diese zusätzliche Aufnahme zwischen den Aufnahmen für die beiden Anschlussstifte angeordnet ist. Bei der eigentlichen Montage und Kontaktierung des Aktors wird der Aktorkörper also in die zugehörige Aufnahme der erfindungsgemäßen Positionierungshilfe eingesetzt und dadurch räumlich fixiert. Anschließend können dann die Anschlussstifte der erfindungsgemäßen Kontaktierungsmatte in die zugehörigen Aufnahmen eingeführt werden, wodurch die Anschlussstifte in einer vorgegebenen räumlichen Lage relativ zu dem Aktorkörper fixiert werden.

In dem Ausführungsbeispiel der Erfindung ist die Positionierungshilfe in Form eines Aufnahmekäfigs aufgebaut und weist eine Kopfplatte und eine im Wesentlichen parallel zu der Kopfplatte angeordnete und mit der Kopfplatte verbundene Bodenplatte auf, wobei in der Kopfplatte und in der Bodenplatte des Aufnahmekäfigs jeweils zwei vorzugsweise schlitzförmige Aufnahmen für die Anschlussstifte und jeweils eine Aufnahme für den Aktorkörper angeordnet sind. Die in der Bodenplatte und der Kopfplatte angeordneten schlitzförmigen Aufnahmen erstrecken sich vorzugsweise im Wesentlichen parallel zu der angrenzenden Seitenfläche des Aktorkörpers, so dass die erfindungsgemäße Kontaktierungsmatte gleichsam um den in dem Aufnahmekäfig befindlichen Aktorkörper herum gewickelt werden kann, wobei die seitlich über die Kontaktierungsmatte hinausragenden Anschlussstifte in die zugehörigen schlitzförmigen Aufnahmen in der Kopfplatte und der Bodenplatte hinein gleiten.

Der Abstand zwischen der Bodenplatte und der Kopfplatte des Aufnahmekäfigs ist deshalb vorzugsweise kleiner als die Länge der Anschlussstifte, damit die in der Kopfplatte und der Bodenplatte angebrachten schlitzförmigen Aufnahmen die Anschlussstifte erfassen können.

Weiterhin ist zu erwähnen, dass die erfindungsgemäße Positionierungshilfe vorzugsweise nicht nur zur Positionierung der Anschlussstifte und der Kontaktierungsmatte relativ zum Aktorkörper bei der Montage dient, sondern vorzugsweise auch mit dem gesamten Aktor vergossen werden kann.

Darüber hinaus weist der Aufnahmekäfig der erfindungsgemäßen Positionierungshilfe vorzugsweise einen Verbindungssteg zwischen der Bodenplatte und der Kopfplatte auf, der einen Kantenschutz für den Aktorkörper bildet, damit kein Berührungskontakt zwischen den Drähten der erfindungsgemäßen Kontaktierungsmatte und den Kanten des Aktorkörpers auftritt, was zur Beschädigung führen könnte.

Ferner umfasst die Erfindung auch ein Verfahren zur Herstellung der vorstehend beschriebenen erfindungsgemäßen Kontaktierungsmatte und zur eigentlichen Kontaktierung des Aktorkörpers mit einer derartigen Kontaktierungsmatte.

Das erfindungsgemäße Verfahren ist vorzugsweise in zwei Schritte aufgeteilt, wobei im ersten Schritt eine Herstellung der Kontaktierungsmatte erfolgt, indem an der Kontaktierungsmatte Anschlussstifte befestigt werden, die später zur Kontaktierung des Aktors dienen.

Nach diesem Herstellungsschritt wird die Kontaktierungsmatte dann so an dem Aktorkörper positioniert, dass sich die Anschlussstifte in ihrer endgültigen Position befinden, woraufhin dann die Drähte mit dem jeweils zugehörigen elektrischen Aktorkontakt an dem Aktorkontakt befestigt werden. Anschließend werden dann die Drähte der Kontaktierungsmatte neben dem Aktorkontakt durchgetrennt, um die erfindungsgemäße Kontaktierungsmatte in entsprechende Teile aufzutrennen.

Bei der Positionierung der erfindungsgemäßen Kontaktierungsmatte an dem Aktorkörper für die eigentliche Kontaktierung wird die erfindungsgemäße Positionierungshilfe eingesetzt.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figuren näher erläutert. Es zeigen:
- Figur 1: eine Perspektivansicht eines Piezostapels eines Piezoaktors mit zwei zugehörigen Anschlussstiften und einer vereinfacht dargestellten Kontaktierungsmatte zur Verbindung des Piezostapels mit den Anschlussstiften,
- Figur 2A: eine Querschnittsansicht aus Fig. 1 mit einem als Positionierungshilfe für die Kontaktierung dienenden Aufnahmekäfig, der in Fig. 1 zur Vereinfachung nicht dargestellt ist,
- Figur 2B: eine Seitenansicht entsprechend Fig. 2A sowie
- Figur 3: eine Seitenansicht einer vereinfacht dargestellten Kontaktierungsmatte im vormontierten Zustand.

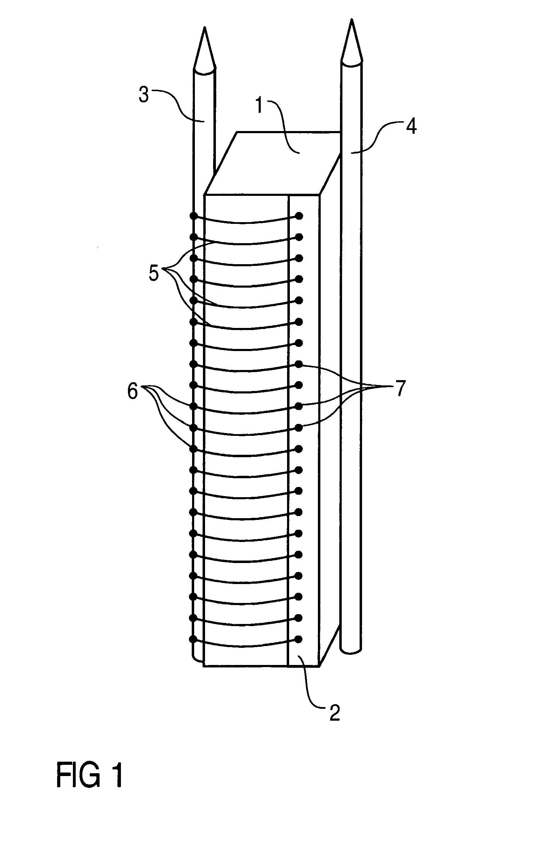

Die Perspektivansicht in Figur 1 zeigt einen Piezostapel 1, der eine Vielzahl von übereinander angeordneten schichtförmigen Piezoelementen aufweist, wobei zwischen den einzelnen Piezoelementen jeweils eine Elektrodenschicht angeordnet ist.

Auf die in der Zeichnung sichtbare vordere Seitenfläche des Piezostapels 1 ist ein Metallisierungsstreifen 2 aufgebracht, der über die gesamte Länge des Piezostapels 1 durchgeht.

Ein weiterer derartiger Metallisierungsstreifen ist auf die in der Zeichnung nicht sichtbare hintere Seitenfläche des Piezostapels 1 aufgebracht, wobei die einzelnen Elektrodenschichten des Piezostapels 1 abwechselnd mit dem vorderen Metallisierungsstreifen 2 und mit dem nicht sichtbaren hinteren Metallisierungsstreifen verbunden sind.

Die elektrische Kontaktierung erfolgt hierbei durch zwei Anschlussstifte 3, 4, die seitlich neben dem Piezostapel 1 angeordnet und parallel zueinander ausgerichtet sind.

Der Anschlussstift 3 ist über eine Vielzahl von elektrisch leitfähigen Drähten 5 mit dem Metallisierungsstreifen 2 verbunden, während der Anschlussstift 4 über verdeckte weitere Drähte mit dem an der Hinterseite des Piezostapels 1 angeordeneten und nicht sichtbaren Metallisierungsstreifen verbunden ist.

Die einzelnen Drähte 5 sind hierbei jeweils durch Lötstellen 6, 7 mit dem Anschlussstift 3 und dem Metallisierungsstreifen 2 verbunden.

Vorteilhaft an der Verbindung des Metallisierungsstreifens 2 mit dem Anschlussstift 3 durch eine Vielzahl von Drähten 5 ist die Tatsache, dass die einzelnen Drähte 5 bei der im späteren Betrieb des Piezoaktors auftretenden Längenänderung des Piezostapels 1 individuell der Bewegung des Piezostapels 1 folgen können, wodurch die Gefahr einer Beschädigung der Drähte 5 herabgesetzt wird.

Zum anderen führt die Vielzahl der Drähte 5 zu einer erhöhten Betriebssicherheit, da auch bei einer Unterbrechung der durch einen der Drähte 5 hergestellten elektrischen Verbindung noch eine sichere Kontaktierung durch die anderen Drähte 5 gewährleistet ist.

Die Verbindung der einzelnen Drähte 5 mit dem Anschlussstift 3 erfolgt jedoch nicht zusammen mit der Verbindung der Drähte 5 mit dem Metallisierungsstreifen 2, sondern in getrennten Arbeitsschritten.

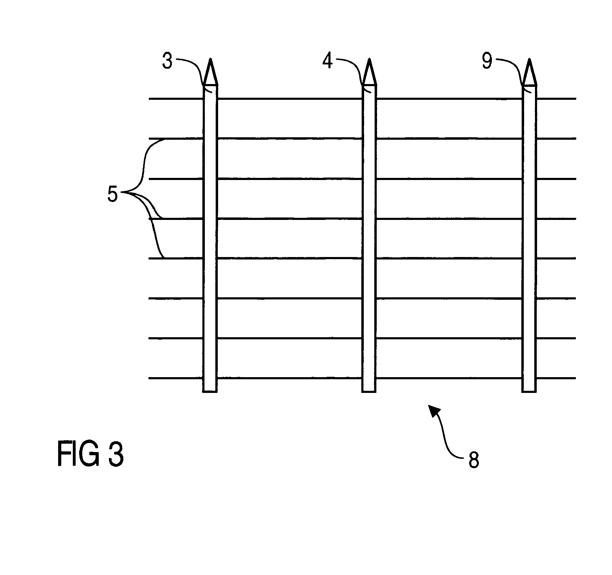

So wird in einem ersten Arbeitsschritt zunächst eine Kontaktierungsmatte 8 hergestellt, die vereinfacht in Figur 3 dargestellt ist.

Hierzu wird ein aus einzelnen elektrisch leitfähigen Drähten 5 gebildetes Drahtgeflecht bereitgestellt.

Anschließend werden dann die beiden Anschlussstifte 3, 4 in das Drahtgeflecht eingeflochten und vorzugsweise an den Drähten 5 festgelötet, um die Kontaktierungsmatte 8 zu bilden. Zusätzlich zu den beiden Anschlussstiften 3, 4 werden weitere Anschlussstifte an den Drähten 5 festgelötet, wobei in der Zeichnung zur Vereinfachung nur ein einziger weiterer Anschlussstift 9 dargestellt ist. Die Kontaktierungsmatte eignet sich deshalb zur Kontaktierung einer Vielzahl von Piezoaktoren, indem die Kontaktierungsmatte 8 entsprechend aufgetrennt wird.

Bei der erfindungsgemäßen Kontaktierungsmatte sind die Anschlussstifte 3, 4, 9 sowie weitere nicht dargestellte Anschlussstifte für weitere Piezoaktoren also bereits im vormontierten Zustand der Kontaktierungsmatte 8 an den Drähten 5 befestigt.

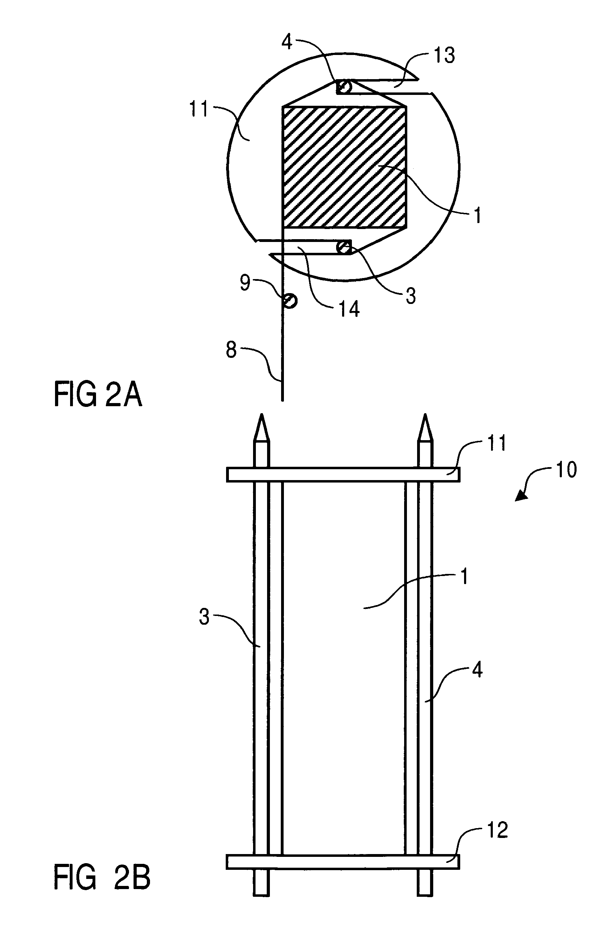

Bei der eigentlichen Kontaktierung wird eine Positionierungshilfe 10 benutzt, die in den Figuren 2A und 2B dargestellt ist. Die Positionierungshilfe 10 besteht im Wesentlichen aus einem Aufnahmekäfig mit einer Kopfplatte 11 und einer Bodenplatte 12, wobei die Kopfplatte 11 parallel zu der Bodenplatte 12 angeordnet und mit der Bodenplatte 12 fest verbunden ist.

Die Kopfplatte 11 und die Bodenplatte 12 weisen jeweils mittig eine Aufnahme für den Piezostapel 1 auf, in die der Piezostapel 1 bei der Montage eingesetzt wird, so dass die Positionierungshilfe 10 den Piezostapel 1 während der Montage und der Kontaktierung räumlich fixiert.

Seitlich neben dieser Aufnahme für den Piezostapel 1 sind in der Kopfplatte 11 und in der Bodenplatte 12 jeweils zwei schlitzförmige Aufnahmen 13, 14 angeordnet, die zur Aufnahme und räumlichen Fixierung der Anschlussstifte 3, 4 dienen. Der Abstand zwischen der Kopfplatte 11 und der Bodenplatte 12 ist deshalb geringer als die Länge der Anschlussstifte 3, 4, damit die schlitzförmigen Aufnahmen 13, 14 die seitlich über den Rande der Kontaktierungsmatte 8 hinaus ragenden freien Enden der Anschlussstifte 3, 4 erfassen können.

Bei der Montage wird die Kontaktierungsmatte 8 dann so um den in der Positionierungshilfe 10 befindlichen Piezostapel 1 herumgewickelt, dass die Anschlussstifte 3, 4 in die zugehörigen schlitzförmigen Aufnahmen 13, 14 hinein gleiten und dort räumlich fixiert werden. Aufgrund der dabei entstehenden Zugspannung liegen die Drähte 5 der Kontaktierungsmatte 8 dann an dem vorderen Metallisierungsstreifen 2 bzw. an dem nicht dargestellten hinteren Metallisierungsstreifen an und werden daraufhin fest gelötet.

Nach dem Festlöten der Drähte 5 an dem Metallisierungsstreifen 2 werden die Drähte 5 auf der dem Anschlussstift 3 abgewandten Seite des Metallisierungsstreifens 2 durchgetrennt und in Richtung des in Figur 1 nicht dargestellten hinteren Metallisierungsstreifens umgeklappt und dort ebenfalls fest gelötet.

Nach diesem Kontaktierungsvorgang kann die gesamte Einheit aus der Positionierungshilfe 10, dem Piezostapel 1, den Anschlussstiften 3, 4 und der Kontaktierungsmatte 8 vergossen werden, um den fertigen Piezoaktor herzustellen.

Die Erfindung ist nicht auf das vorstehend beschriebene bevorzugte Ausführungsbeispiel beschränkt. Vielmehr ist eine Vielzahl von Varianten und Abwandlungen möglich, die ebenfalls von dem Erfindungsgedanken Gebrauch machen und deshalb in den Schutzbereich fallen.

## Patentansprüche

1. Kontaktierungsmatte (8) zur elektrischen Verbindung eines Anschlussstifts (3, 4, 9) eines Aktors mit einem zugehörigen Aktorkontakt (2) eines Aktorkörpers (1) des Aktors, insbesondere für einen Piezoaktor, mit mehreren elektrisch leitfähigen Drähten (5), wobei der Anschlussstift (3, 4, 9) des Aktors an den Drähten (5) vormontiert befestigt ist und die Drähte (5) ein Drahtgeflecht bilden,
**dadurch gekennzeichnet,**
**dass** der Anschlussstift in das Drahtgeflecht eingeflochten ist.

2. Kontaktierungsmatte (8) nach Anspruch 1,
**dadurch gekennzeichnet,**
**dass** die Drähte (5) im Wesentlichen parallel zueinander angeordnet sind, während der Anschlussstift (3, 4, 9) im Wesentlichen rechtwinklig zu den Drähten (5) angeordnet ist.

3. Kontaktierungsmatte (8) nach einem der vorhergehenden Ansprüche,
**dadurch gekennzeichnet,**
**dass** mehrere Anschlussstifte (3, 4, 9) an den Drähten (5) vormontiert befestigt sind.

4. Kontaktierungsmatte (8) nach Anspruch 3,
**dadurch gekennzeichnet,**
**dass** die Anschlussstifte (3, 4, 9) im Wesentlichen äquidistant in einem bestimmten Abstand angeordnet sind.

5. Kontaktierungsmatte (8) nach Anspruch 4,
**dadurch gekennzeichnet,**
**dass** der Abstand zwischen den Anschlussstiften (3, 4, 9) im Wesentlichen gleich der im fertig montierten Zustand gegebenen Verbindungslänge zwischen einem Aktorkontakt (2) und dem zugehörigen Anschlussstift (3) ist.

6. Kontaktierungsmatte (8) nach einem der vorhergehenden Ansprüche,
**dadurch gekennzeichnet,**
**dass** der Anschlussstift oder die Anschlussstifte (3, 4, 9) seitlich über die Drähte (5) hinausragen.

7. Kontaktierungsmatte (8) nach einem der vorhergehenden Ansprüche,
**dadurch gekennzeichnet,**
**dass** die Drähte (5) Schussfäden eines Drahtgeflechts bilden und durch quer verlaufende Kettfäden miteinander verbunden sind.

8. Aktor, insbesondere Piezoaktor, mit einer Kontaktierungsmatte (8) nach einem der vorhergehenden Ansprüche.

9. Positionierungshilfe (10) für eine Kontaktierungsmatte (8) nach einem der Ansprüche 1 bis 8 zur Kontaktierung eines Piezoaktors mit
mindestens zwei Aufnahmen (13, 14) zur Aufnahme und räumlichen Fixierung jeweils eines Anschlussstifts (3, 4) der Kontaktierungsmatte (8), wobei zwischen den Aufnahmen (13, 14) für die Anschlussstifte (3, 4) eine Aufnahme für einen Aktorkörper (1) angeordnet ist, um die Anschlussstifte (3, 4) in einer vorgegebenen räumlichen Lage relativ zu dem Aktorkörper (1) zu fixieren, und
mit einem Aufnahmekäfig mit einer Kopfplatte (11) und einer im Wesentlichen parallel zu der Kopfplatte (11) angeordneten und mit der Kopfplatte (11) verbundenen Bodenplatte (12), wobei die Kopfplatte (11) und die Bodenplatte (12) jeweils zwei Aufnahmen (13, 14) für die Anschlussstifte (3, 4) und jeweils eine Aufnahme für den Aktorkörper (1) aufweisen,
wobei
die Aufnahmen (13, 14) für die Anschlussstifte (3, 4) in der Kopfplatte (11) und der Bodenplatte (12) schlitzförmig ausgebildet sind und die Anschlussstifte (3, 4) in die schlitzförmigen Aufnahmen einführbar (13, 14) sind.

10. Positionierungshilfe (10) nach Anspruch 9,
**dadurch gekennzeichnet,**
**dass** der Abstand zwischen der Bodenplatte (11) und der Kopfplatte (12) des Aufnahmekäfigs kleiner ist als die Länge der Anschlussstifte (3, 4).

11. Positionierungshilfe (10) nach einem der Ansprüche 9 oder 10,
**dadurch gekennzeichnet,**
**dass** die Kopfplatte (11) des Aufnahmekäfigs durch mindestens einen Verbindungssteg mit der Bodenplatte (12) verbunden ist,
wobei der Verbindungssteg einen Kantenschutz für den Aktorkörper (1) bildet.

12. Verfahren zur Herstellung eines Aktors
mit den Schritten:
- Positionierung einer vormontierten Kontaktierungsmatte (8), die einen an mehreren elektrisch leitfähigen Drähten (5) befestigten Anschlussstift aufweist, an dem Aktorkörper (1) mittels einer Positionierungshilfe (10) nach einem der Ansprüche 9 bis 11, so dass sich der Anschlussstift (3, 4) in seiner endgültigen Stellung befindet,
- Verbindung der Drähte (5) mit einem elektrischen Aktorkontakt (2) an dem Aktorkörper (1),
- Durchtrennung der Drähte (5) neben dem Aktorkontakt (2).

13. Verfahren nach Anspruch 12,
**dadurch gekennzeichnet,**
**dass** der Anschlussstift (3, 4) an den Drähten (5) festgelötet wird.

14. Verfahren nach einem der Ansprüche 12 oder 13,
**dadurch gekennzeichnet,**
**dass** die Drähte (5) ein Drahtgeflecht bilden, wobei der Anschluss in das Drahtgeflecht eingeflochten wird.

## Claims

1. Contact mat (8) for electrically connecting a terminal pin (3, 4, 9) of an actuator to an associated actuator contact (2) of an actuator body (1) of the actuator, in particular for a piezoactuator, having a plurality of electrically conductive wires (5), the terminal pin (3, 4, 9) of the actuator being attached to the wires (5) in a pre-assembled state and the wires (5) forming a wire mesh,
**characterised in that**
the terminal pin is woven into the wire mesh.

2. Contact mat (8) according to claim 1,
**characterised in that**
the wires (5) are arranged essentially parallel to one another, while the terminal pin (3, 4, 9) is disposed essentially at right angles to the wires (5).

3. Contact mat (8) according to one of the preceding claims,
**characterised in that**
a plurality of terminal pins (3, 4, 9) are attached to the wires (5) in a pre-assembled state.

4. Contact mat (8) according to claim 3,
**characterised in that**
the terminal pins (3, 4, 9) are arranged essentially equidistantly at a specific pitch.

5. Contact mat (8) according to claim 4,
**characterised in that**
the pitch between the terminal pins (3, 4, 9) is essentially equal to the connection length, given in the fully assembled state, between an actuator contact (2) and the associated terminal pin (3).

6. Contact mat (8) according to one of the preceding claims,
**characterised in that**
the terminal pin or the terminal pins (3, 4, 9) project laterally beyond the wires (5).

7. Contact mat (8) according to one of the preceding claims,
**characterised in that**
the wires (5) form the weft threads of a wire mesh and are interconnected by means of transversely running warp threads.

8. Actuator, in particular piezoactuator, having a contact mat (8) according to one of the preceding claims.

9. Positioning aid (10) for a contact mat (8) according to one of claims 1 to 8 for electrically contacting a piezoactuator, having
at least two retainers (13, 14) for retaining and spatially fixing one terminal pin (3, 4) of the contact mat (8) in each case, a retainer for an actuator body (1) being disposed between the retainers (13, 14) for the terminal pins (3, 4) in order to fix the terminal pins (3, 4) in a predetermined spatial position relative to the actuator body (1), and
having a retainer cage with a head plate (11) and a floor plate (12) arranged essentially parallel to the head plate (11) and connected to the head plate (11), the head plate (11) and the floor plate (12) each having two retainers (13, 14) for the terminal pins (3, 4) and in each case a retainer for the actuator body (1),
wherein the retainers (13, 14) for the terminal pins (3, 4) in the head plate (11) and the floor plate (12) are embodied in the shape of a slot and the terminal pins (3, 4) can be introduced into the slot-shaped retainers (13, 14).

10. Positioning aid (10) according to claim 9,
**characterised in that**
the distance between the floor plate (11) and the head plate (12) of the retainer cage is less than the length of the terminal pins (3, 4).

11. Positioning aid (10) according to one of claims 9 or 10,
**characterised in that**
the head plate (11) of the retainer cage is connected to the floor plate (12) by at least one connecting bridge, the connecting bridge forming an edge protection for the actuator body (1).

12. Method for producing an actuator,
comprising the steps:
- positioning a pre-assembled contact mat (8), which has a terminal pin secured to a plurality of electrically conductive wires (5), on the actuator body (1) by means of a positioning aid (10) according to one of claims 9 to 11 so that the terminal pin (3, 4) is located in its final position,
- connecting the wires (5) to an electrical actuator contact (2) on the actuator body (1),
- severing the wires (5) near to the actuator contact (2).

13. Method according to claim 12,
**characterised in that**
the terminal pin (3, 4) is soldered to the wires (5).

14. Method according to one of claims 12 or 13,
**characterised in that**
the wires (5) form a wire mesh, the terminal being woven into the wire mesh.

## Revendications

1. Tapis de mise en contact (8) permettant de relier électriquement une broche de raccordement (3, 4, 9) d'un actionneur à un contact d'actionneur (2) correspondant d'un corps d'actionneur (1) de l'actionneur, notamment pour un actionneur piézoélectrique, et pourvu de plusieurs fils électroconducteurs (5), la broche de raccordement (3, 4, 9) de l'actionneur étant, lors d'un prémontage, fixée aux fils (5) et les fils (5) formant un réseau de fils,
**caractérisé en ce que**
la broche de raccordement est entrelacée dans le réseau de fils.

2. Tapis de mise en contact(8)selon la revendication 1,
**caractérisé en ce que**
les fils (5) sont disposés sensiblement parallèlement les uns aux autres alors que la broche de raccordement (3, 4, 9) est disposée sensiblement à angle droit par rapport aux fils (5).

3. Tapis de mise en contact (8) selon l'une des revendications précédentes,
**caractérisé en ce que**
plusieurs broches de raccordement (3, 4, 9) sont, lors d'un prémontage, fixées aux fils (5).

4. Tapis de mise en contact (8) selon la revendication 3,
**caractérisé en ce que**
les broches de raccordement (3, 4, 9) sont disposées selon un écart donné, sensiblement de manière équidistante.

5. Tapis de mise en contact (8) selon la revendication 4,
**caractérisé en ce que**
l'écart entre les broches de raccordement (3, 4, 9) est sensiblement le même que la longueur de liaison existant à l'état entièrement monté entre un contact d'actionneur (2) et la broche de raccordement correspondante (3).

6. Tapis de mise en contact (8) selon l'une des revendications précédentes,
**caractérisé en ce que**
la broche de raccordement ou les broches de raccordement (3, 4, 9) dépassent les fils (5) de manière latérale.

7. Tapis de mise en contact (8) selon l'une des revendications précédentes,
**caractérisé en ce que**
les fils (5) forment les fils de trame d'un réseau de fils et sont reliés entre eux par des fils de chaîne s'étendant transversalement.

8. Actionneur, notamment actionneur piézoélectrique, pourvu d'un tapis de mise en contact (8) selon l'une des revendications précédentes.

9. Aide de positionnement (10) pour un tapis de mise en contact (8) selon l'une des revendications 1 à 8 permettant la mise en contact d'un actionneur piézoélectrique et comportant au moins deux logements (13, 14) permettant de recevoir et de fixer dans l'espace respectivement une broche de raccordement (3, 4) du tapis de mise en contact (8), entre les logements (13, 14) pour les broches de raccordement (3, 4) étant disposé un logement pour un corps d'actionneur (1), afin de fixer les broches de raccordement (3, 4) dans une position spatiale préalablement définie par rapport au corps d'actionneur (1), et
une cage de logement pourvue d'une plaque supérieure (11) et d'une plaque inférieure (12) disposée sensiblement parallèlement à la plaque supérieure (11) et reliée à la plaque supérieure (11), la plaque supérieure (11) et la plaque inférieure (12) présentant respectivement deux logements (13, 14) pour les broches de raccordement (3, 4) et respectivement un logement pour le corps d'actionneur (1),
les logements (13, 14) pour les broches de raccordement (3, 4) ménagés dans la plaque supérieure (11) et dans la plaque inférieure (12) étant réalisés en forme de fente et les broches de raccordement (3, 4) pouvant être insérées dans les logements (13, 14) en forme de fente.

10. Aide de positionnement (10) selon la revendication 9,
**caractérisé en ce que**
l'écart entre la plaque inférieure (12) et la plaque supérieure (11) de la cage de logement est inférieur à la longueur des broches de raccordement (3, 4).

11. Aide de positionnement (10) selon l'une des revendications 9 ou 10,
**caractérisé en ce que**
la plaque supérieure (11) de la cage de logement est reliée à la plaque inférieure (12) par au moins une barre de jonction,
la barre de jonction formant un protège-arête pour le corps d'actionneur (1).

12. Procédé de fabrication d'un actionneur comprenant les étapes suivantes :
- le positionnement sur le corps d'actionneur (1) d'un tapis de mise en contact prémonté (8) qui présente une broche de raccordement fixée à plusieurs fils électroconducteurs (5), et ce au moyen d'une aide de positionnement (10) selon l'une des revendications 9 à 11 de sorte que la broche de raccordement (3, 4) se trouve dans sa position définitive,
- la liaison des fils (5) à un contact d'actionneur électrique (2) au niveau du corps d'actionneur (1),
- la section des fils (5) à côté du contact d'actionneur (2).

13. Procédé selon la revendication 12,
**caractérisé en ce que**
la broche de raccordement (3, 4) est fixée aux fils (5) par soudage.

14. Procédé selon l'une des revendications 12 ou 13,
**caractérisé en ce que**
les fils (5) forment un réseau de fils, la broche de raccordement étant entrelacée dans le réseau de fils.
